Europäisches Patentamt

European Patent Office

Office européen des brevets

(19)

(11) Publication number: **0 421 599 A2**

# EUROPEAN PATENT APPLICATION

(12)

(21) Application number: 90309467.0

(22) Date of filing: 30.08.90

(51) Int. Cl.⁵: **H01L 23/057**, H01L 23/498, H01L 23/367

The title of the invention has been amended (Guidelines for Examination in the EPO, A-III, 7.3).

(30) Priority: **09.09.89 GB 8920452**

(43) Date of publication of application:
**10.04.91 Bulletin 91/15**

(84) Designated Contracting States:
**DE FR GB**

(71) Applicant: **International Business Machines Corporation**
**Old Orchard Road**
**Armonk, N.Y. 10504(US)**

(72) Inventor: **Lazenby, Kate**
**15 Castle Lane**
**Chandlers Ford, Hampshire SO5 3AH(GB)**
Inventor: **Cox, Allen Ronald**
**3 The Deanery, North Millers Dale**
**Chandlers Ford, Hampshire S05 1TL(GB)**

(74) Representative: **Burt, Roger James, Dr.**
**IBM United Kingdom Limited Intellectual**
**Property Department Hursley Park**
**Winchester Hampshire SO21 2JN(GB)**

(54) **Integral protective enclosure for TAB device mounted on a flexible printed circuit board.**

(57) A flexible electrical assembly is presented. The assembly includes a TAB device (3), mounted on one side of a flexible circuit board (8). An array of printed electrical connections extend on either side of the circuit board (8) for connecting terminals (2) of the device to terminals of other devices mounted on the circuit board. An individual heatsink (9) is mounted by leaves (1) to that side of the flexible circuit board (8) remote from the device. The device (3) itself is rigidly enclosed between the heatsink (9) and a protective cover (7). The protective cover (7) has receptacles (12) cooperative with the leaves (1) for attaching the cover (7) to that side of the flexible circuit board (8) adjacent to the device (3).

EP 0 421 599 A2

## INTEGRAL PROTECTIVE ENCLOSURE FOR TAB OR SIMILAR DELICATE ASSEMBLY MOUNTED LOCALLY ON A FLEXIBLE PRINTED CIRCUIT BOARD

The present invention relates to a protective enclosure for a Tape Automated Bonding (TAB) device mounted on a flexible printed circuit board (PCB) during assembly and life. In particular, the protective enclosure of the present invention has good thermal conduction to assist the dissipation of heat from the TAB device.

For the purpose of the following description and claims, a TAB device refers to a TAB or similarly delicate electrical device assembly.

A problem generally associated with a flexible electrical assemblies and in particular with those electrical assemblies including one or more TAB devices concerns mechanical failure of delicate, electrical connections between the flexible circuit board and the devices. These connections can be damaged or broken by uncontrolled flexure of the electrical assembly during post manufacturing processes. Similar breakages can also occur where the assembly is flexed during normal installation and operation of a product.

Another problem generally associated with flexible electrical assemblies including TAB devices concerns removal of excess heat generated within the TAB devices during operation. Prolonged exposure to excessive heat can reduce the operational lifetime of the devices.

EPA103067 describes apparatus for cooling a multiplicity of integrated circuit modules mounted on flexible circuit board. The modules are orientated so that the top surface of each makes contact with a common planar surface which is part of a cooling plate. A coefficient of thermal conductivity between the cooling plate and each module is minimised by maximising associated areas of contact with thermally conductive lubricant. A pressure means, acting upon the flexible circuit board is directed to press the modules and the flexible circuit board toward the common cooling plate.

A disadvantage with this apparatus is that no protection is provided against mechanical failure of TAB connections during manufacture of the electrical assembly. Furthermore, the presence of a cooling plate in the electrical assembly limits the flexibility of the flexible circuit board.

EPO116396 describes similar cooling apparatus comprising a slab like heatsink material having raised pillars for protruding through holes in the flexible circuit board to make thermal contact with the flat undersides of integrated circuit modules mounted on the circuit board.

A disadvantage with this apparatus is that good thermal contact between the TAB devices and the heatsink cannot be achieved. Furthermore, as described in the previous example, a common clamping format is suggested for maintaining good thermal contact between the heatsink and the modules by which means the flexing characteristics of the flexible electrical assembly are restricted.

An aim of the present invention is therefore to provide for a TAB or similar device, a protective enclosure which has good heatsinking properties and does not restrict the flexibility of the flexible electrical assembly.

In accordance with the present invention, there is now provided a flexible electrical assembly comprising a TAB device mounted on one side of a flexible circuit board, an array of printed electrical connections which may extend on either side of the circuit board in order to connect terminals of the device to terminals of other devices mounted on the circuit board, an individual heatsink having locating means for mounting the heatsink on a different side of the flexible circuit board to that on which the device is mounted, characterised in that the device is rigidly enclosed between the heatsink and a cover utilising the locating means of the heatsink for attachment to a side of the flexible circuit board on which the device is attached, in order to provide mechanical protection of the device. A mechanically protective enclosure for a TAB device mounted on a flexible circuit board is therefore provided comprising two portions in which a first portion is a punched, formed metal heatsink having locating means, for mounting the heatsink on the flexible circuit board, comprising a plurality of tabs, and a second, protective cover portion which is a resilient moulding having locating means which are receptive to said tabs.

This has the advantage that the TAB device can be bonded directly to the heatsink, to optimise thermal conductivity, by a process involving only two mechanical parts, which subsequently become part of a mechanically protective assembly enclosing the TAB device. Furthermore the simplicity of this assembly is attractive for automated production and therefore low manufacturing cost. The heatsink preferably has an open structure for ease of cleaning with no traps for contaminants. Contaminants can lead to insulation resistance failure via dendritic growth between adjacent electrical connections.

In a particularly preferred embodiment of the present invention, the area of the flexible circuit board occupied by the heatsink is similar to the area of the flexible circuit board occupied by the protective cover so that a plurality of conductive wires which connect the device to the array of connections printed on the flexible circuit board are mechanically protected. This has the advantage that the flexible electrical assembly is thereby protected against failure modes which result from shock and vibrational forces during the operation and manufacture.

In preferred examples of the present invention, the protective cover incorporates a preloaded member which defines a thickness of a film of thermally conductive adhesive compound interposed between the device and the heatsink during a bonding process. This has the advantage that there is no requirement for additional fixture complexity during the manufacture of a TAB electrical assembly in which the TAB device is bonded to a heatsink.

An embodiment of the present invention will now be described by way of example with reference accompanying diagrams in which:

Figure 1 is a cross sectional view of a flexible electrical assembly comprising TAB device, protective cover, and heatsink, mounted on a flexible circuit board.

Figure 2 is a perspective drawing which further illustrates the flexible electrical assembly shown in figure 1.

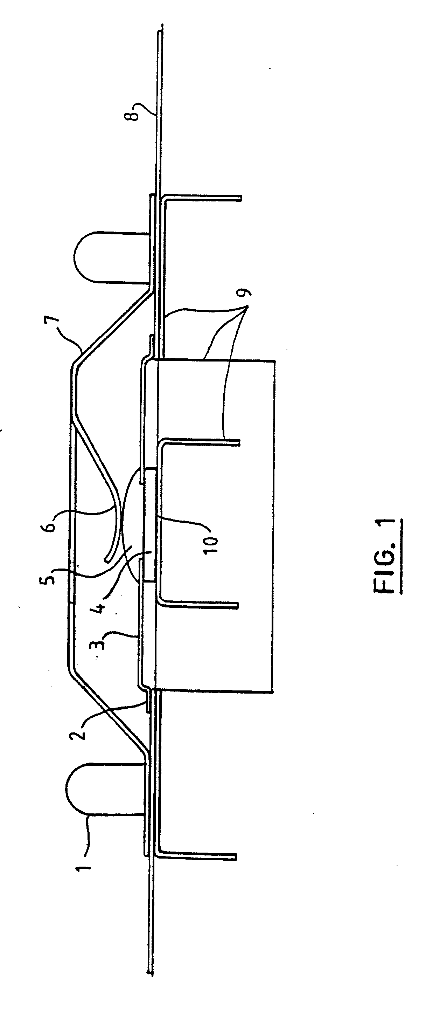

As shown in figure 1, a TAB device 3 includes a silicon chip 4, an encapsulant seal 5 to protect electrical connections to the chip, and an array of TAB outer leaf electrical connections 2 from the chip. These outer leaf connections are delicate and can be damaged during manufacturing processes.

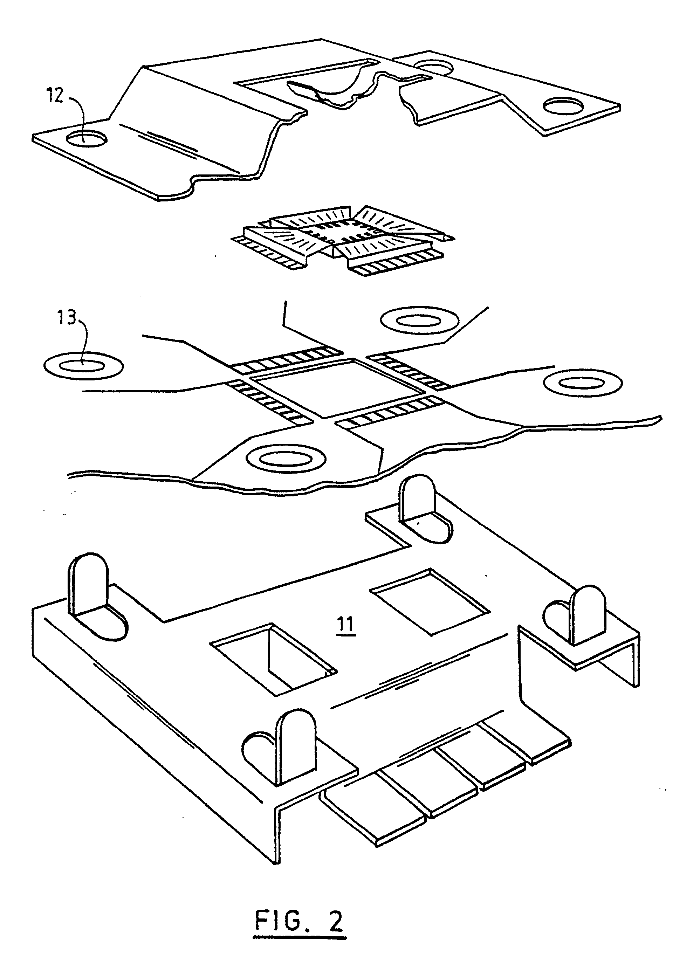

A heatsink 9, compatible with the TAB device, is initially punched out of sheet metal. In preferred embodiments of the invention, the heatsink is stamped from aluminium sheet. However, it will be appreciated that the heatsink may be from other thermally conductive materials in other embodiments of the invention. The heatsink is formed to provide a thermal contact area 11, shown in Figure 2, for making thermal contact with an exposed surface of the TAB device via a thin layer of thermally conductive adhesive 10. Heat dissipating fins extend from the heatsink for dissipating heat from the TAB device. The heatsink is secured to one side of the flexible circuit board 8 by crimping leaves 1 cooperative with a protective plastic cover 7.

The protective plastic cover includes a moulded-in spring 6 to pressurise the adhesive between the heatsink and the chip surface before the adhesive cures. This optimises a thermal bond between the heatsink and the chip.

Figure 2 illustrates the order in which the heatsink, TAB device, flexible circuit board and protective cover are assembled. Receptive holes 12 in the protective cover allign with the crimping leaves of the heatsink. The flexible circuit board contains locating holes 13 through which the crimping leaves pass, prior to passing through the aforementioned receptive holes. The assembled combination of the heatsink, the flexible circuit material, and the protective cover enclosing the device is thereby secured by splaying the protruding crimping leaves against the protective cover.

## Claims

1. A flexible electrical assembly comprising:
a TAB device (3), mounted on one side of a flexible circuit board (8);
an array of printed electrical connections which may extend on either side of the circuit board for connecting terminals of the device (3) to terminals of other devices mounted on the circuit board (8);
an individual heatsink (9) having locating means (1) for mounting the heatsink (9) on that side of the flexible circuit board (8) remote from the device (3);
characterised in that the device (3) is rigidly enclosed between the heatsink (9) and a protective cover (7); the protective cover (7) having receptacles (12) cooperative with the locating means (1) for attaching the cover to that side of the circuit board (8) adjacent to the device (3).

2. An electrical assembly as claimed in claim 1 wherein the area of the circuit board (8) occupied by the heatsink (9) is similar to the area of the circuit board (8) occupied by the protective cover (7) so that a plurality conductive wires (2) coupling the device (3) to the array of connections printed on the circuit board (8) are mechanically protected.

3. An electrical assembly as claimed in claim 1 wherein the protective cover (7) comprises an integral preloaded member (6) for defining a thickness of a film of a thermally conductive adhesive compound (10) interposed between the device (3) and the heatsink (9) during a bonding process.

4. A protective enclosure for a TAB device (3) mounted on a flexible circuit board (8); the protective enclosure comprising:
a first portion in the form of a metal heatsink (9) having locating means for mounting the heatsink (9) on the circuit board (8);
and a second portion in the form of a resilient cover (7) having receptacles (12) for receiving the locating means (1).

5. A flexible electrical assembly comprising: a TAB device (3) mounted on a flexible circuit board (8) and a protective enclosure as claimed in claim 4.

6. An electrical assembly as claimed in claim 3 or claim 5 wherein the heatsink (9) comprises the plurality of leaves (1) for cooperating with the receptacles (12) of the cover (7), a plurality of integral heat dissipating fins, and a device bonding area for permitting heat transfer from a surface of the device (3) to the heatsink (9).

7. An electrical assembly as claimed in claim 6 wherein the circuit board (8) remains flexible on the exterior of the protective enclosure and substantially rigid on the interior of the protective enclosure.

8. An electrical assembly as claimed in claim 7 wherein circuit board (8) comprises a plurality of locating holes (13) for receiving the leaves (1) of the heatsink (9).

9. An electrical assembly as claimed in claim 8 wherein the receptacles (12) are in the form of holes positioned around the periphery of the cover (7) for aligning with the locating holes in the circuit board to receive the leaves (1).

10. An electrical assembly as claimed in claim 9 wherein the leaves (1) can be splayed to secure the heatsink (9) to the circuit board (8) and the cover (7).

FIG. 1

12

13

11

# FIG. 2